(19) Europäisches Patentamt
European Patent Office
Office européen des brevets

(11) **EP 1 933 400 B1**

(12) **EUROPÄISCHE PATENTSCHRIFT**

(45) Veröffentlichungstag und Bekanntmachung des Hinweises auf die Patenterteilung:
**22.01.2020 Patentblatt 2020/04**

(51) Int Cl.:
***H01L 51/52*** *(2006.01)*

(21) Anmeldenummer: **07024342.3**

(22) Anmeldetag: **14.12.2007**

(54) **Organisches Leuchtbauelement**

Organic lighting component

Composant d'éclairage organique

(84) Benannte Vertragsstaaten:
**DE FR GB NL**

(30) Priorität: **14.12.2006 DE 102006059509**

(43) Veröffentlichungstag der Anmeldung:
**18.06.2008 Patentblatt 2008/25**

(73) Patentinhaber: **Novaled GmbH**
**01099 Dresden (DE)**

(72) Erfinder:
• **Murano, Sven**
**01099 Dresden (DE)**

• **Birnstock, Jan**
**01187 Dresden (DE)**
• **Blochwitz-Nimoth, Jan**
**01097 Dresden (DE)**

(74) Vertreter: **Bittner, Thomas L.**
**Boehmert & Boehmert**
**Anwaltspartnerschaft mbB**
**Pettenkoferstrasse 22**
**80336 München (DE)**

(56) Entgegenhaltungen:
**EP-A1- 1 701 395   EP-A2- 1 460 884**
**WO-A2-01/56000   US-A1- 2005 174 064**
**US-A1- 2006 066 223**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung betrifft ein organisches Leuchtbauelement, insbesondere organische Leuchtdiode, mit einem Leuchtelement und einer von dem Leuchtelement umfassten Leuchtfläche.

Hintergrund der Erfindung

Organische Leuchtbauelemente in Form organischer Leuchtdioden (OLEDs), welche farbiges Licht, insbesondere Weißlicht emittieren, haben in den vergangenen Jahren verstärkte Aufmerksamkeit gewonnen. Es ist allgemein anerkannt, dass die Technologie organischer Leuchtbauelemente ein großes Potenzial für mögliche Anwendungen im Bereich der Beleuchtungstechnik besitzt. Mittlerweile erreichen organische Leuchtdioden Leistungseffizienzen, welche im Bereich von konventionellen elektrischen Glühbirnen liegen (vgl. Forrest et al., Adv. Mat. 7(2004)624).

Organische Leuchtdioden werden üblicherweise mit Hilfe eines Schichtaufbaus gebildet, der auf einem Substrat angeordnet wird. In dem Schichtaufbau ist zwischen einer Elektrode und einer Gegenelektrode eine organische Schichtanordnung angeordnet, sodass die organische Schichtanordnung über die Elektrode und die Gegenelektrode mit einer elektrischen Spannung beaufschlagt werden kann. Die organische Schichtanordnung ist aus organischen Materialien hergestellt und umfasst einen lichtemittierenden Bereich. In dem lichtemittierenden Bereich rekombinieren Ladungsträger, nämlich Elektronen und Löcher, die beim Anlegen der elektrischen Spannung an die Elektrode und die Gegenelektrode in die organische Schichtanordnung injiziert und dort zu dem lichtemittierenden Bereich transportiert werden. Eine wesentliche Effizienzsteigerung bei der Lichterzeugung konnte erreicht werden, indem in die organische Schichtanordnung elektrisch dotierte Schichten integriert wurden.

Organische Leuchtbauelemente können in verschiedensten Anwendungsbereichen genutzt werden, um Licht beliebiger Farbe zu erzeugen, wozu insbesondere Anzeigeeinrichtungen, Beleuchtungseinrichtungen und Signaleinrichtungen gehören.

In einer Ausführungsform können die organischen Leuchtbauelemente so gestaltet werden, dass sie Weißlicht abgeben. Derartige Bauelemente haben das Potenzial, eine bedeutende Alternative zu den momentan am Markt dominierenden Beleuchtungstechnologien darzustellen, beispielsweise Glühlampen, Halogenlam-pen, Niederspannungsleuchtstoffröhren oder der glei-chen.

Trotzdem sind für eine erfolgreiche Kommerzialisierung der Technologie der organischen Leuchtbauelemente noch wesentliche technische Probleme zu lösen. Insbesondere ist es eine Herausforderung, mittels OLED-Bauelementen große Lichtmengen zu erzeugen, welche für allgemeine Beleuchtungsanwendungen benötigt werden. Die von einem OLED-Bauelement abgegebene Lichtmenge wird durch zwei Faktoren bestimmt. Dieses sind die Helligkeit im Bereich der Leuchtfläche des Bauelementes und die Größe der Leuchtfläche. Die Helligkeit eines organischen Leuchtbauelementes lässt sich nicht beliebig steigern. Darüber hinaus wird auch die Lebensdauer organischer Bauelemente wesentlich von der Helligkeit beeinflusst. Wird beispielsweise die Helligkeit eines OLED-Bauelementes verdoppelt, so reduziert sich dessen Lebensdauer um den Faktor zwei bis vier. Als Lebensdauer ist hierbei die Zeit definiert, die vergeht, bis das OLED-Bauelement beim Betrieb mit einem konstanten Strom auf seine halbe Ausgangshelligkeit abgefallen ist.

Die Leuchtfläche eines OLED-Bauelementes für Beleuchtungsanwendungen muss entsprechend einer gewünschten abgegebenen Lichtmenge gewählt werden. Es ist anzustreben, dass sie im Bereich von einigen Quadratzentimetern bis hin zu einer Größe von über einem Quadratmeter liegt.

OLED-Bauelemente werden als elektrisches Bauelement typischerweise bei niedrigen Spannung im Bereich von etwa 2V bis etwa 20V betrieben. Der durch das OLED-Bauelement fließende Strom wird durch die Leuchtfläche bestimmt. Schon bei einer relativ kleinen Leuchtfläche des OLED-Bauelementes von etwa 100cm$^2$ würde bei einer angenommenen Stromeffizienz von 50cd/A und einer Anwendungshelligkeit von 5000cd/m$^2$ ein Strom von 1A benötigt.

Ein organisches Leuchtbauelement mit einem solchen Strom zu versorgen, stellt jedoch ein erhebliches technisches Problem dar und lässt sich in kommerziellen Beleuchtungsanwendungen nicht ohne weiteres auf preiswerte Art und Weise lösen. Bekanntermaßen ist die elektrische Verlustleistung der Stromzuführung proportional zum elektrischen Widerstand der Zuleitung und zum Quadrat des fließenden Stromes. Um also die Verlustleitung auch bei großen Strömen gering zu halten, müssten elektrische Zuleitungen mit einem sehr niedrigen Widerstand, also einem großen Querschnitt genutzt werden. Gerade dieses ist aber bei einem Bauelement zu vermeiden, dessen herausragende Eigenschaft unter anderem die flache Bauweise ist. Sofern größere Bauteilflächen benötigt werden, müsste der Versorgungsstrom weiter gesteigert werden, wodurch sich die Probleme bei der Stromversorgung weiter verschärfen würden.

Aus diesem Grund wurde vorgeschlagen, mehrere OLED-Elemente in einem organischen Leuchtbauelement elektrisch in Reihe zu schalten (vgl. GB 2 392 023 A). Hierbei wird die Gesamtfläche des organischen Leuchtbauelementes in einzelne OLED-Leuchtelemente aufgeteilt, welche in einer oder mehreren Reihenschaltungen elektrisch miteinander verknüpft sind. Auf diese Weise wird die Betriebsspannung des Leuchtbauelements etwa um einen Faktor erhöht, welcher der Anzahl der in Reihe geschalteten OLED-Leuchtelemente entspricht, wobei der fließende Strom um den gleichen Faktor verringert wird. Durch die Verringerung des Betriebsstromes bei gleichzeitiger Erhöhung der Betriebsspannung kann so bei gleicher Leistung eine deutliche Vereinfachung der Ansteuerung des Leuchtbauelementes erzielt werden, da es im Allgemeinen deutlich leichter ist, anstelle eines hohen Stromes eine hohe Spannung an ein elektrisches Bauelement heranzuführen. Ein weiter Vorteil, der sich aus der Nutzung der Reihenschaltung von OLED-Leuchtelementen ergibt, besteht darin, dass im Falle eines Kurzschlusses zwischen den beiden Elektroden, nämlich der Kathode und der Anode, eines der OLED-Leuchtelemente zwar ein Teil der Leuchtfläche des organischen Leuchtbauelementes ausfällt, insgesamt aber das Leuchtbauelement weiterhin Licht emittiert und die insgesamt emittierte Lichtmenge sogar aufgrund der nun für die verbleibenden nicht ausgefallenen OLED-Leuchtelemente erhöhten Betriebsspannung weitgehend unverändert bleibt. Somit kann ein solches Leuchtbauelement mit einer Reihenschaltung von OLED-Leuchtelementen auch nach einem Kurzschluss eines der OLED-Leuchtelemente weiterhin genutzt werden. Im Gegensatz dazu ist ein organisches Leuchtbauelement, welches über lediglich ein einzelnes OLED-Leuchtelement verfügt, bei einem Kurzschluss zwischen Anode und Kathode unbrauchbar.

Für die Herstellung von OLED-Leuchtbauelemente mit einer Reihenschaltung von OLED-Leuchtelementen ist jedoch ein komplexes Herstellungsverfahren notwendig. Zum einen ist es erforderlich, die Elektrode, welche auf dem tragenden Substrat gebildet wird, zu strukturieren, um die den einzelnen in Reihe geschalteten OLED-Leuchtelementen zugeordneten Elektroden zu definieren. Darüber hinaus ist es notwendig, die organischen Schichtanordnungen der einzelnen OLED-Leuchtelemente und die hierauf gebildete Deckelektrode zu strukturieren. Hierfür kommen verschiedene bekannte Verfahren in Betracht.

Im Fall von OLEDs, bei denen organische Materialien verwendet werden, die durch Vakuumverdampfungen aufgebracht werden können, ist ein geeignetes Verfahren zum Strukturieren das Aufdampfen mittel Schattenmasken. Weitere Verfahren sind beispielsweise das Aufbringen mittels LITI ("*Laser Induced Thermal Imaging"*), bei dem von einem Trägerfilm, welcher mit organischem Material beladen ist, zumindest ein Teil des organischen Materials auf das Substrat übertragen wird, in dem der Trägerfilm punktgenau mittels Laser erhitzt wird. Das LITI-Verfahren kann jedoch nur für die Strukturierung der organischen Schichtanordnung der OLED-Leuchtelemente verwendet werden. Zum Strukturieren der Deckelektrode, die ihrerseits üblicherweise aus Metallen wie Silber, Aluminium oder Magnesium oder einem leitfähigen transparenten Oxid wie Indium-Zinn-Oxid (ITO) besteht, muss ein anderes Strukturierungsverfahren herangezogen werden.

Die Strukturierungsverfahren haben einen erheblichen Aufwand im Rahmen der Herstellung des organischen Leuchtbauelementes zur Folge, wodurch hohe Kosten entstehen. Für den Fall der Verwendung von Schattenmasken besteht darüber hinaus das Problem einer begrenzten Auflösung, das heißt der Abstand zwischen den einzelnen in Reihe geschalteten OLED-Leuchtelementen ist durch die Abmessungen der Stege der Schattenmaske begrenzt. Hierbei ist zu beachten, dass in Abhängigkeit von der Größe der Aussparungen zwischen den Stegen der Schattenmaske eine gewisse Stegbreite der Schattenmaske erforderlich ist, um die mechanische Stabilität der Schattenmaske zu gewährleisten.

Um also die Strukturierung mittels Schattenmasken zu vereinfachen, ist es sinnvoll, auf eine Feinauflösung der mittels Schattenmaske strukturierten Bereiche zu verzichten. Dies kann dadurch geschehen, dass die in Reihe geschalteten OLED-Leuchtelemente relativ groß gestaltet werden, beispielsweise mit einer Größe von etwa 1cm$^2$. Hierdurch wird es ermöglicht, Schattenmasken mit einer geringen Präzision zu verwenden, welche sich mittels einfacher Verfahren ausrichten lassen, beispielsweise mittels Ausrichten unter Verwendung von Haltestiften. Solche Verfahren sind in der Massenproduktion deutlich günstiger als Methoden zur Feinjustierung, die beispielsweise auf der Ausrichtung mittels Positioniermarken unter einem Mikroskop basieren.

Weiterhin ist die Verwendung von Schattenmasken ein limitierender Faktor hinsichtlich der erreichbaren Prozessierungszeiten, da eine Feinjustierung der Schattenmasken einen nicht vernachlässigbaren Anteil an der Gesamtprozessdauer hat. Mittels Verwenden eines weniger genauen Verfahrens lassen sich die mit der Positionierung verbundenen Prozesszeiten verringern.

Für bestimmte Verfahren zum Herstellen von organischen Leuchtbauelementen, beispielsweise die kontinuierliche Rolle-zu-Rolle Methode, ergeben sich bei der bekannten Nutzung von Schattenmasken weitere Probleme. Zum einem muss in einem solchen Verfahren die Schattenmaske mit dem Substrat, auf dem der Schichtstapel mit den Elektroden und der organischen Schichtanordnung zu bilden ist, mitgeführt werden, ohne das die Position der Schattenmaske relativ zum Substrat geändert wird. Zum anderen muss in einem solchen Verfahren die Schattenmaske zum Substrat ausgerichtet werden, wobei im Rolle-zu-Rolle Verfahren das Substrat gegebenenfalls angehalten werden muss. Somit ist es wünschenswert, einen Prozess zur Verfügung zu haben, bei dem die Verwendung von hochauflösenden Schattenmasken nicht notwendig ist.

Die Nutzung von weniger genauen Schattenmasken führt nicht wirklich zu einer Optimierung, da sie mit erheblichen Nachteilen verbunden ist. Hierbei können lediglich größere OLED-Teilflächen gebildet werden. Sofern eine dieser Teilflächen durch einen Kurzschluss ausfällt, wird ein großer Teil der Leuchtfläche des Bauelementes inaktiv, das heißt sie bleibt dunkel beim Betrieb des Leuchtbauelementes. Hierdurch wird jedoch das Gesamtbauelement in seiner Funktionalität wesentlich beeinträchtigt. Zwar fällt in einer Reihenschaltung über dem kurzgeschlossenen OLED-Leuchtelement wenig Spannung ab, wodurch sich die Spannung für die anderen OLED-Leuchtelemente erhöht, weswegen dann insgesamt das ausgesendete Licht nur wenig verändert wird, jedoch ist der visuelle Eindruck des organischen Leuchtbauelementes wesentlich verschlechtert. Dieses ist für Anwendungszwecke nicht akzeptabel. Das Leuchtbauelement wird vom Betrachter als schadhaft wahrgenommen. Darüber hinaus führen elektrische Kurzschlüsse in OLED-Bauelementen dazu, dass nahezu der gesamte Strom, welcher normalerweise über die Gesamtfläche verteilt fließt, nur durch die Kurzschlussstelle geleitet wird. Hierdurch kommt es lokal zu einer starken Erwärmung, wodurch Ohm'sche Verluste entstehen und die Gefahr besteht, dass sich an der Kurzschlussstelle der Widerstand deutlich erhöht und somit die Kurzschlussstelle isolierend wird, beispielsweise aufgrund einer Delamination organischer oder anorganischer Schichten. Es droht die Gefahr, dass die zum Schutz des Leuchtbauelementes aufgebrachte Verkapselung diesem lokalen thermischen Stress nicht standhält, insbesondere bei Verwendung einer Dünnschichtverkapselung, wie sie heutzutage für OLED-Beleuchtungselemente der Zukunft angedacht ist. Diese nachteiligen Effekte werden um so größer je größer die Fläche des OLED-Bauelementes ist.

Das Dokument US 2005/174064 A1 beschreibt eine Anordnung für ein organisches Bauelement, das in besonderer Weise gegenüber Störungen bzw. Fehlern tolerant sein soll.

Das Dokument US 2006/066223 A1 zeigt ein organisches Bauelement mit mehreren elektrisch parallel geschalteten Teilelektroden.

Das Dokument WO 01/56000 A2 betrifft ein lichtemittierendes Bauelement, das mit einem transparenten Substrat, einer ersten transparenten Elektrode, einer zweiten Gegenelektrode und einer Schicht aus elektrolumineszierenden organischen Material, die zwischen den beiden Elektroden liegt, gebildet ist.

Das Dokument EP 1 701 395 A1 beschreibt ein transparentes lichtemittierendes Bauelement.

## Zusammenfassung der Erfindung

Aufgabe der Erfindung ist es, ein verbessertes organisches Leuchtbauelement der eingangsgenannten Art zu schaffen, bei dem die vorangehend geschilderten Probleme des Standes der Technik vermieden sind.

Diese Aufgabe wird erfindungsgemäß durch ein organisches Leuchtbauelement nach dem unabhängigen Anspruch 1 gelöst. Vorteilhafte Weiterbildungen der Erfindung sind Gegenstand von abhängigen Unteransprüchen.

Die Erfindung umfasst den Gedanken ein organisches Leuchtbauelement, insbesondere eine organische Leuchtdiode, mit einem Leuchtelement und einer von dem Leuchtelement umfassten Leuchtfläche zu schaffen, die mittels einer Elektrode, einer Gegenelektrode und einer organischen Schichtanordnung gebildet ist, welche zwischen der Elektrode und der Gegenelektrode angeordnet und in elektrischem Kontakt mit der Elektrode und der Gegenelektrode ist. Im Bereich der Leuchtfläche angeordnete und beim Anlegen einer elektrischen Spannung an die Elektrode und die Gegenelektrode Licht abgebende Abschnitte der organischen Schichtanordnung weisen einen einheitlichen organischen Materialaufbau auf und sind auf mehreren elektrisch parallel geschalteten Teilelektroden der Elektrode gebildet, bei denen ein seitlicher Abstand zwischen benachbarten Teilelektroden kleiner als die Breite der benachbarten Teilelektroden ist. Ein einheitlicher organischer Materialaufbau der organischen Schichtanordnung in den Abschnitten auf den parallel geschalteten Teilelektroden bedeutet in diesem Zusammenhang, dass aufgrund der gleichartigen Materialzusammensetzung Licht gleicher Farbe abgegeben wird. Das Licht kann eine beliebige Farbe des sichtbaren Spektrums aufweisen. Individuell können die Abschnitte jeweils Emittermaterialien umfassen, die Licht unterschiedlicher Farbe abgeben, welches sich dann für jeden Abschnitt individuell zu einem Mischlicht mischt, insbesondere Weißlicht.

Die vorgesehene konstruktiver Ausgestaltung der mehreren elektrisch parallel geschalteten Teilelektroden der Elektrode hat den Vorteil, dass die Leistungseffizienz des gesamten organischen Leuchtbauelementes auch hoch bleibt, wenn beispielsweise im Bereich einer der Teilelektroden ein elektrischer Kurzschluss lokal auftritt. Das optische Erscheinungsbild des Leuchtbauelementes im Betrieb bleibt auch bei einem solchen lokalen elektrischen Kurzschluss für den Betrachter weitgehend einwandfrei. Die Parallelschaltung verhindert einen Totalausfall des Leuchtelementes. Das vorgesehene Verhältnis von seitlichem Abstand zwischen benachbarten Teilelektroden und der Breite der benachbarten Teilelektroden sichert auch im Kurzschlussfall ein gewünschtes optisches Erscheinungsbild für den Betrachter der Leuchtfläche.

Die vorgesehene Strukturierung der Elektrode in mehrere elektrisch parallel geschaltete Teilelektroden ist prozesstechnisch ohne wesentlichen Mehraufwand umsetzbar. Im Fall einer substratseitigen Ausbildung der Elektrode kann dieses mittels Photolithographie, aber auch mittels Druckverfahren ausgeführt werden. Es ist aber auch ermöglicht, weiterhin die als solche bekannte einfache Schattenmaskentechnologie mit geringer Positioniergenauigkeit zu verwenden. Insbesondere im Zusammenhang mit letztgenannter Technologie ist es in einer Ausführungsform bevorzugt, dass ein von der organischen Schichtanordnung eingenommener Bereich im wesentlichen gleich groß zu einem von der Elektrode mit den mehreren Teilelektroden eingenommenen Bereich ist. Schattenmasken mit geringer Positioniergenauigkeit können einfach, schnell und kostengünstig in einem Produktionsprozess angewendet werden.

Der seitliche Abstand zwischen den benachbarten Teilelektroden ist kleiner als die Hälfte der Breite der benachbarten Teilelektroden. Bei einer zweckmäßigen Ausgestaltung der Erfindung kann vorgesehen sein, dass der seitliche Abstand zwischen den benachbarten Teilelektroden kleiner als ein Drittel der Breite der benachbarten Teilelektroden ist. Je kleiner der Abstand zwischen benachbarten Teilelektroden im Vergleich zur Breite der Teilelektroden ist, umso weniger macht sich für den Betrachter der Ausfall einer oder mehrere Teilelektroden bei einem elektrischen Kurzschluss für das optische Erscheinungsbild des Betrachters bemerkbar. Zweckmäßig kann der Abstand zwischen benachbarten Teilelektroden im Verhältnis zur Breite der benachbarten Teilelektroden deshalb auch so gewählt werden, dass der Ausfall einer Teilelektrode zwischen zwei hierzu benachbarten und im Betrieb noch leuchtenden Teilelektroden vom menschlichen Auge im optischen Erscheinungsbild nicht auflösbar ist.

Die mehreren Teilelektroden sind als Streifenelektroden gebildet. Streifenelektrode bedeutet in diesem Zusammenhang, dass die Teilelektroden entlang ihrer Ausdehnung eine im wesentlichen gleich bleibende Materialbreite aufweisen, wie es für Streifen üblich ist. Der Streifen selbst verläuft entlang einer einfach oder mehrfach gekrümmten Linie oder einer Zickzack-Linie. Zweckmäßigerweise greifen Krümmungen oder Zickzack-Kanten benachbarter Teilelektroden in gegenüberliegende Vertiefungen, wodurch das möglichst einheitliche Leuchtbild der Leuchtfläche verbessert ist.

Bei einer vorteilhaften Ausgestaltung der Erfindung kann vorgesehen sein, dass die organische Schichtanordnung im Bereich der Leuchtfläche im wesentlichen durchgehend gebildet ist. Ist die organische Schichtanordnung im wesentlichen durchgehend im Bereich der Leuchtfläche gebildet, vereinfacht dieses die Herstellung, da die organische Schichtanordnung im wesentlichen in einem gemeinsamen Herstellungsschritt aufgebracht werden kann. Leuchten tun dann aber nur die Teilbereiche der organischen Schichtanordnung, die im Bereich der Teilelektroden angeordnet sind. Zwischenbereiche bleiben im Betrieb dunkel. Im Bereich der Teilelektroden sind organische Bauelemente gebildet, die auch als organische Leuchtdioden (OLED) bezeichnet werden und gemeinsam zur Leuchtfläche beitragen. Es ist deshalb auch nicht von Schaden, wenn die Zwischenbereiche beim Herstellen des Leuchtelementes unter Umständen beschädigt werden, wie dieses auftreten kann, wenn die Elektrode als Deckelektrode gebildet wird und hierbei mittels Laserlithographie eine Strukturierung in die Teilelektroden ausgeführt wird, nachdem die Deckelektrode auf die organische Schichtanordnung aufgebracht ist.

Eine Weiterbildung der Erfindung kann vorsehen, dass die Anzahl der mehreren Teilelektroden der Elektrode wenigstens 10 beträgt, bevorzugt wenigstens 30 und weiter bevorzugt wenigstens 100. Die Anzahl von 10 Teilelektroden bildet einen Mindestwert, ab dem die beabsichtigte Vermeidung eines Totalausfalles des Leuchtbauelementes im Falle eines Kurzschlusses erzielt werden kann. Für eine Anzahl von etwa 30 Teilelektroden kann bereits davon ausgegangen werden, dass im Falle eines Kurzschlusses durch Verwendung geeigneter Streufolien oder anderer Streuelemente für den Betrachter bei einem geeigneten Mindestabstand der Defekt einer Teilelektrode mit bloßem Auge nicht mehr wahrgenommen wird. Sofern die Anzahl der Teilelektroden etwa 100 beträgt, ist ein eventueller Kurzschluss auch ohne die Verwendung einer Streufolie für den Betrachter mit bloßem Auge bei einem gewissen Mindestabstand nicht mehr sichtbar. Diese Angaben zur Anzahl der Teilelektroden sind als Näherungswerte zu betrachten, da eine genauere Aussage über den Effekt eines Kurzschlusses neben den technischen Details des Lcuchtbauelementes wie elektrischer Schichtwiderstand des Elektrodenmaterials, elektrischer Widerstand der Gegenelektrode, Betriebsspannung und - strom und Anzahl und Dimension der Teilelektroden auch die Kenntnis der Betriebshelligkeit verlangt.

Bei einer bevorzugten Ausgestaltung der Erfindung kann vorgesehen sein, dass eine maximale Betriebsspannung für das Leuchtelement von weniger als 10V, bevorzugt von weniger als 6V und weiter bevorzugt von weniger als 4V verwendet wird. 10V ist die ungefähre Betriebsspannung eines einfachen organischen lichtemittierenden Bauelementes vom iii-Typ. 6V entspricht der ungefähren Betriebsspannung eines aufwändigeren organischen lichtemittierenden Bauelementes vom iii-Typ, wie sie als solche im Stand der Technik bekannt sind. 4V ist die ungefähre Betriebsspannung eines organischen lichtemittierenden Bauelementes vom pin-Typ, wie es als solches im Stand der Technik bekannt ist. Darüber hinaus kann 10V, 6V und 4V auch als die ungefähren Betriebsspannungen für einfache, zweifach gestapelte und dreifach gestapelte pin-OLEDs betrachtet werden.

Eine bevorzugte Weiterbildung der Erfindung sieht vor, dass eine maximale Betriebshelligkeit im Bereich der Leuchtfläche von wenigstens $500 cd/m^2$, bevorzugt von wenigstens $1000 cd/m^2$ und weiter bevorzugt von wenigstens $5000 cd/m^2$ wird. Der Wert von $500\ cd/m^2$ stellt einen Helligkeitsgrenzwert dar, ab dem der Einsatz der vorliegenden Erfindung in der Beleuchtungstechnik als besonders zweckmäßig erachtet wird. Sofern ein Beleuchtungsbauteil eine leuchtende Gesamtfläche von 1 Quadratmeter aufweist, entspricht die Lichtleistung bei einer Helligkeit von $500\ cd/m^2$ etwa der halben Lichtleistung einer 100W Glühbirne. Die Helligkeit von $1000\ cd/m^2$ entspricht etwa der Schwelle, bei der ein Beleuchtungselement gerade noch nicht als blendend vom Betrachter wahrgenommen wird, sofern es beispielsweise in einer Beleuchtungssituation als Deckenleuchte eingesetzt wird. $5000\ cd/m^2$ entsprechen einer Helligkeit, die als günstiger Wert für eine Maximierung zwischen Lichtleistung pro leuchtende Fläche des Leuchtbauelementes und Lebensdauer des Leuchtbauelementes erachtet wird. Für eine kommerzielle Optimierung eines Produktes kann es sinnvoll sein, eine Helligkeit in diesem Bereich anzustreben, um eine ausgewogene Balance zwischen den Anschaffungs- und den Herstellungskosten des Bauteils einerseits und der Betriebsleistung und der Lebensdauer andererseits zu schaffen.

Eine vorteilhafte Ausführungsform der Erfindung sieht vor, dass die mehreren Teilelektroden jeweils mit einem Schichtwiderstand und der Breite gebildet sind, bei denen sich für das Produkt von Schichtwiderstand und Breite ein Wert zwischen 10 und 1000mm*Ohm/Quadrat ergibt, bevorzugt zwischen 100 und 1000mm*Ohm/Quadrat.

Bevorzugt sieht eine Fortbildung der Erfindung vor, dass flächig überlappend mit der Leuchtfläche ein Licht streuendes Element gebildet ist. Auf diese Weise wird der Ausfall von einer oder mehreren Teilelektroden und somit der hiermit verbundenen organischen Bereiche, insbesondere aufgrund eines elektrischen Kurzschlusses, im optischen Erscheinungsbild beim Betrieb des Leuchtbauelementes für den Betrachter noch effektiver unterdrückt.

Bei einer vorteilhaften Ausgestaltung der Erfindung kann vorgesehen sein, dass das Licht streuende Element ein Licht streuendes Substrat umfasst, auf welches die Elektrode, die Gegenelektrode und die organischen Schichtanordnung gestapelt sind.

Eine Weiterbildung der Erfindung kann vorsehen, dass das Licht streuende Element eine Streufolie umfasst.

Eine bevorzugte Weiterbildung der Erfindung sieht vor, dass das Leuchtelement gemäß mindestens einer Bauart ausgewählt aus der folgenden Gruppe von Bauarten ausgeführt ist: transparentes Leuchtelement, top-emittierendes Leuchtelement, bottom-emittierendes und beidseitig emittierendes Leuchtelement.

Bei einer zweckmäßigen Ausgestaltung der Erfindung kann vorgesehen sein, dass die Leuchtfläche eine Flächengröße von mehreren Quadratzentimetern aufweist.

Eine vorteilhafte Ausführungsform der Erfindung sieht vor, dass die organische Schichtanordnung eine oder mehrere dotierte Ladungsträgertransportschichten aufweist. Die Verwendung von dotierten organischen Schichten trägt wesentlich zur Verbesserung der Leistungseffizienz organischer Leuchtbauelemente bei (vgl. beispielsweise DE 100 58 578 C1). Es können eine p- oder eine n-Dotierung oder eine Kombination hiervon verwendet werden. Mit Hilfe der Dotierungsmaterialien wird eine verbesserte elektrische Leitfähigkeit in den elektrisch dotierten Bereichen ausgebildet.

Bevorzugt sieht die Fortbildung der Erfindung vor, dass das Leuchtelement mit mindestens einem weiteren Leuchtelement gleicher Bauweise elektrisch in Reihe geschalten ist. Hierdurch sind die elektrische Parallelschaltung der mehreren Teilelektroden in den einzelnen Leuchtelementen und die elektrische Reihenschaltung von mehreren Leuchtelementen in einem organischen Leuchtbauelement miteinander kombiniert.

Bei einer vorteilhaften Ausgestaltung der Erfindung kann vorgesehen sein, dass das Leuchtelement mit wenigstens zehn weiteren Leuchtelementen gleicher Bauweise elektrisch in Reihe geschalten ist, bevorzugt mit wenigstens siebenundzwanzig weiteren Leuchtelementen, weiter bevorzugt mit wenigstens fünfundfünfzig weiteren Leuchtelementen. Bei einer Reihenschaltung von zehn Leuchtelementen ergibt sich für eine Betriebsspannung von 4V pro Leuchtelement eine Gesamtspannung von 40V, wodurch das Bauelement mittels einer Spannungsquelle betrieben werden kann, welche dem Schutzkleinspannungsbereich entspricht. Eine übliche Spannungsgrenze für diesen Bereich ist eine Wechselspannung von 42V. Bei der Kombination von etwa 27 Bauelementen mit einer Betriebsspannung von 4V ergibt sich eine Gesamtspannung für das Leuchtbauelement von etwa 110V, eine häufig zur Verfügung stehende Netzspannung. Bei der Kombination von etwa 55 Bauelementen mit einer Betriebsspannung von 4V ergibt sich eine Gesamtspannung für das Leuchtbauelement von etwa 220V, eine ebenfalls häufig zur Verfügung stehende Netzspannung. Mittels Anpassung der Betriebsspannung des Leuchtbauelementes an zur Verfügung stehende Netzspannungen kann eine Ansteuerung des Bauteils dergestalt vereinfacht werden, dass lediglich ein Gleichrichter zwischen die Spannungsquelle und das Bauteil geschaltet werden muss. Die mehreren Leuchtelemente können konfiguriert sein, Licht unterschiedlicher Farben abzugeben.

Weiterhin kann es vorgesehen sein, dass zwei Reihenschaltungen in einem Leuchtbauelement so kombiniert werden, dass die zur Verfügung stehende Wechselspannung genutzt wird, d.h. dass bei beiden anliegenden Phasen eine der Reihenschaltungen Licht emittiert. Für eine solche Anordnung kann vorgesehen sein, eine Frequenzerhöhung der Versorgungs-Wechselspannung vorzunehmen, um dem Betrachter eine kontinuierliche Lichtemission ohne Flimmern darzustellen.

Die Elektrode mit den mehreren elektrisch parallel geschalteten Teilelektroden kann aus unterschiedlichen Materialien hergestellt werden. Hierzu gehören insbesondere entartet Halbleiter-Oxidmaterialien oder Metalle. In einer Ausgestaltung ist die Elektrode aus Indium-Zinn-Oxid (ITO) gebildet. Da die Prozessierung von ITO mittels Photolithographie erfolgen kann, wobei eine Feinstrukturierung zum Ausbilden der Teilelektroden problemlos und ohne zusätzliche Kosten möglich ist, erfordert die Unterteilung der Elektrode in die Teilelektroden keinen zusätzlichen Aufwand. Der Abstand zwischen den ITO-Teilelektroden kann sehr gering gehalten werden, beispielsweise 10μm. Es ergibt sich für das menschliche Auge insgesamt ein homogenes Bild der Leuchtfläche. Kommt es in einer solchen Anordnung zu einem Kurzschluss zwischen den Elektroden, so verhindert die Strukturierung des ITOs in Teilelektroden einen Totalausfall des Leuchtelementes über den gesamten Bereich. Dies ist dadurch begründet, dass ITO einen vergleichsweise hohen Schichtwiderstand hat, woraus sich aufgrund des hohen Aspektverhältnisses der Teilelektroden auch ein hoher Widerstand der ITO-Teilelektroden ergibt. Da im normalen Betrieb aufgrund der Parallelschaltung der Teilelektroden jedoch nur ein sehr kleiner Strom über die einzelne Teilelektrode fließt, bleibt die Effizienz des organischen Leuchtbauelementes hoch. Erst im Moment des Kurzschlusses zwischen der Elektrode und der Gegenelektrode ergibt sich ein lokal höherer Strom, welcher jedoch durch den großen Widerstand der ITO-Teilelektroden limitiert ist. Im Fall eines Kurzschlusses wird also nur auf der Fläche der betroffenen ITO-Teilelektrode kein Licht mehr emittiert. Der restliche Bereich der Leuchtfläche des Leuchtelementes wird mit nahezu unveränderter Helligkeit weiterleuchten,

Eine zweckmäßige Weiterbildung der Erfindung sieht vor, dass ein Abstand zwischen benachbart zueinander gebildeten Randabschnitten der Gegenelektroden benachbarter Leuchtelemente größer als die jeweilige Breite der mehreren Teilelektroden, bevorzugt größer als das Dreifache der jeweiligen Breite der mehreren Teilelektroden und weiter bevorzugt größer als das Zehnfache der jeweiligen Breite der mehreren Teilelektroden ist. Die benachbart zueinander gebildeten Randabschnitte der Gegenelektroden von benachbarten Leuchtelementen sind bei einer Betrachtung von oben einander gegenüberliegend angeordnet.

Das vorgeschlagene organische Leuchtbauelement kann für unterschiedliche Anwendungszwecke verwendet werden. Hierzu gehören insbesondere Beleuchtungseinrichtungen und Anzeigeeinrichtungen wie Displays. Im Fall einer Anzeigeeinrichtung können Pixelelemente, die individuell gemäß einer der vorgeschlagenen Ausgestaltungen des organischen Lcuchtbauelementes ausgeführt sind, miteinander kombiniert werden, um mehrfarbige Displays zu schaffen, beispielsweise RGB-Displays.

Das vorgeschlagene Leuchtbauelement bleibt auch bei einer starken mechanischen Beschädigung noch funktionstüchtig. Es kann vorgesehen sein, das Bauteil mittels einer sogenannten Dünnschichtverkapselung gegen Umwelteinflüsse wie Luftsauerstoff und Wasser abzuschließen. In einem solchen Fall befindet sich die Verkapselung direkt auf der Oberfläche des Bauteils, es existiert kein Hohlraum zwischen Verkapselung und Schichtanordnung, wie dies bei konventioneller Verkapselung der Fall ist, beispielsweise mittels eines aufgeklebten Glasdeckels. In einer solchen Konfiguration ist der Weiterbetrieb ermöglicht, auch im Falle einer mechanischen Beschädigung wie sie beim Durchstoßen oder Durchschießen des Bauteils mit einem Gegenstand auftreten kann. Ein solcher Weiterbetrieb kann insbesondere im Bereich der Fahrzeugtechnik oder in militärischen Anwendungen erwünscht sein.

Beschreibung bevorzugter Ausführungsbeipiele der Erfindung

Die Erfindung wird im folgenden anhand von Ausführungsbeispielen unter Bezugnahme auf eine Zeichnung näher erläutert. Hierbei zeigen:

Fig. 1 eine schematische Darstellung eines organischen Leuchtbauelementes mit zwei elektrisch in Reihe geschalteten Leuchtelementen, und

Fig. 2 eine vergrößerte Darstellung eines Abschnitts des organischen Leuchtbauelementes nach Fig. 1.

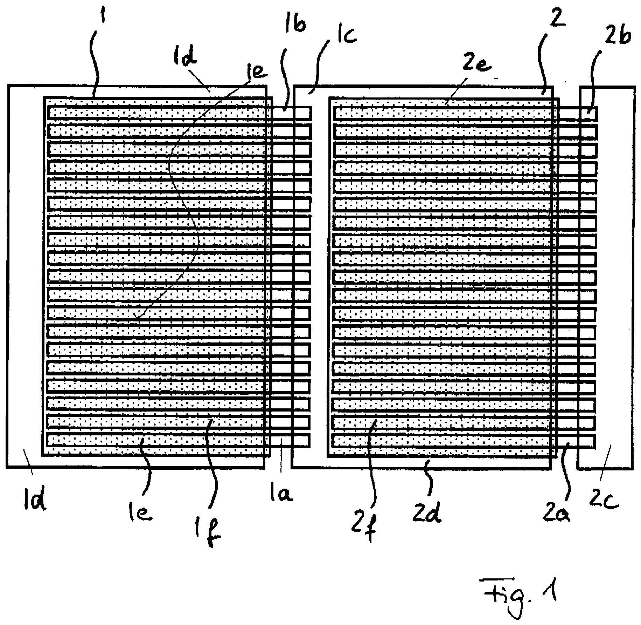

Fig. 1 (nicht Teil dieser Erfindung) zeigt eine schematische Darstellung eines organischen Leuchtbauelementes mit zwei elektrisch in Reihe geschalteten Leuchtelementen 1, 2. Die beiden Leuchtelemente 1, 2 verfügen jeweils über eine Elektrode 1a, 2a, die als eine Anordnung von mehreren parallel verlaufenden und streifenförmig gebildeten Teilelektroden 1b, 2b gebildet ist. Die Teilelektroden 1b, 2b stehen mit einem jeweiligen Kontaktanschluss 1c, 2c in Verbindung und sind so elektrisch parallel geschaltet. Die beiden Leuchtelemente 1, 2 verfügen darüber hinaus über eine jeweilige Gegenelektrode 1d, 2d, die als flächige Elektrode gebildet ist. In einer vereinfachten Ausführungsform (nicht dargestellt) ist das organische Leuchtbauelement von nur einem Leuchtelement gebildet, welches in analoger Weise zu den Leuchtelementen 1, 2 ausgeführt ist.

Bei der Ausgestaltung nach Fig. 1 ist zwischen der Elektrode 1a, 2a mit den Teilelektroden 1b, 2b und der Gegenelektrode 1d, 2d jeweils ein organischer Schichtstapel 1e, 2e, nämlich eine Anordnung von Schichten aus organischen Materialien, in Kontakt mit der Elektroden 1a, 2a und der Gegenelektrode 1d, 2d gebildet. Der organische Schichtstapel 1e, 2e umfasst einen lichtemittierenden Bereich, so dass mit den Leuchtelementen 1, 2 beim Anlegen einer elektrischen Spannung an die Elektrode 1a, 2a und die Gegenelektrode 1d, 2d Licht erzeugt werden kann. Innerhalb der Leuchtelemente 1, 2 weist der zugehörige organische Schichtstapel 1e, 2e eine im wesentlichen einheitliche Materialzusammensetzung auf. Eine mit Hilfe der Teilelektroden 1d, 2d und des organischen Schichtstapels 1e, 2e bei den beiden Leuchtelementen 1, 2 jeweils gebildete Leuchtfläche lf, 2f gibt deshalb jeweils Licht einheitlicher Farbe ab, wobei sich die Farbe des abgegebenen Lichtes für die beiden Leuchtelemente 1, 2 unterscheiden kann. Hierbei kann auch vorgesehen sein, dass die Leuchtflächen 1f, 2f Weißlicht abgebend gebildet sind, welches sich als Mischung von Licht unterschiedlicher Farben ergibt, das von verschiedenen organischen Emittermaterialien in den organischen Schichtstapel 1d, 2d abgegeben wird.

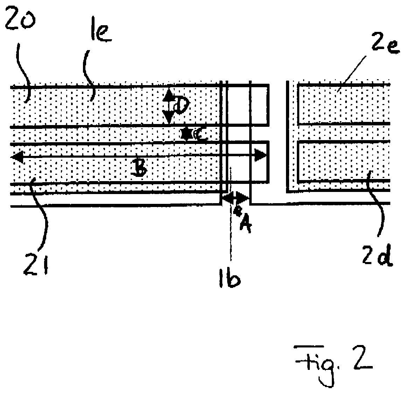

Fig.2 (nicht Teil dieser Erfindung) zeigt eine vergrößerte Darstellung eines Abschnitts des organischen Leuchtbauelementes aus Fig. 1. Die Teilelektroden 1b, 2b weisen eine Breite D auf. Der Abstand zwischen benachbarten Teilelektroden 20, 21 ist in Fig. 2 mit C bezeichnet. Die Teilelektroden 1b, 2b verfügen über eine Länge B. In Fig. 2 bezeichnet A einen Abstand zwischen benachbart zueinander gebildeten Randabschnitten der Gegenelektroden 1d, 2d zweier Leuchtelemente.

Neben den vorangehend beschriebenen Parametern können weitere Parameter für die Optimierung des organischen Leuchtbauelementes genutzt werden: Anzahl der in Reihe geschalteten Leuchtelemente M, Anzahl der Teilelektroden pro Elektrode N, Widerstand des organischen Leuchtbauelementes in Betrieb (pro Fläche) R, Schichtwiderstand S, Betriebshelligkeit H und Betriebsspannung U. Um die allgemeinen Prinzipien der Erfindung in Abhängigkeit vom konkreten Anwendungsfall anzupassen, können ein oder mehrere der vorangehend ausgeführten Parameter individuell angepasst werden.

Nachfolgend werden weitere Ausführungsbeispiele im Detail erläutert.

Auf einem Glassubstrat (nicht dargestellt) werden fünf in Reihe geschaltete Leuchtelemente aufgebracht. Sie bilden zusammen das organische Leuchtbauelement. Eine Grundelektrode aus ITO wird photolithographisch in streifenförmige Teilelektroden strukturiert. Die Teilelektroden sind jeweils mit einem Anschlusskontakt verbunden. Die Länge B der Teilelektroden ist 20mm; ihre Breite D beträgt jeweils 1mm. Der Schichtwiderstand des ITO beträgt 20Ohm/Quadrat. Die Anzahl paralleler Teilelektroden beträgt N = 100; ihr Abstand C ist 20$\mu$m. Auf die Leuchtelemente wird jeweils großflächig ein grünes Licht emittierender organischer Schichtbereich aufgedampft mit einer Stromeffizienz E von 60cd/A. Hierzu wird ein als solcher bekannter organischer Schichtstapel mit dem grünes Licht emittierenden, phosphoreszenten Emittermaterial $Ir(ppy)_3$ verwendet (vgl. He et al., Appl. Phys. Lett., 85(2004)3911)). Eine Helligkeit H von 6000cd/m$^2$ wird bei einer Spannung U von 4V und einer Stromdichte von etwa 10mA/cm$^2$ erreicht. Der Abstand A zwischen den metallischen Deckelektroden benachbarter Leuchtelemente beträgt 3mm.

Entsteht nun in der Mitte einer der Teilelektroden aus ITO ein Kurzschluss, so wird der Strom durch das im Bereich dieser Teilelektrode gebildete OLED-Bauteil nur noch durch den Bahnwiderstand der ITO-Zuleitung zu dem Bauteil begrenzt. Der Zuleitungswiderstand beträgt in diesem konkreten Fall: S*(B/2D), also 200Ohm. Der Faktor ½ rührt daher, dass der Kurzschluss in der Mitte der Teilelektrode liegt.

Die im der verbleibenden Teilelektroden gebildeten OLED-Bauteile sind alle noch funktionsfähig. Ihr Gesamtwiderstand beträgt, einschließlich des ITO Bahnwiderstandes, etwa 20Ohm, wie sich leicht aus der Betriebsspannung, der Fläche und der Stromdichte berechnen lässt. Hier wird näherungsweise angenommen, dass die OLED-Bauteile auf der gesamten Leuchtfläche mit einer homogenen Helligkeit leuchten. Tatsächlich leuchten die Bereiche der OLED-Bauteile etwas dunkler, in denen aufgrund der Stromzuführung durch die Elektrode ein gewisser Spannungsabfall zum Tragen kommt.

Es ergibt sich, dass knapp 10% des Stroms über den Kurzschluss abfließen und über 90% über die verbleibenden OLED-Bauteile. Das bedeutet weiterhin, dass das Leuchtelement auch bei einem solchen Kurzschluss noch über 90% des Lichtes abgibt. Für das gesamte organische Leuchtbauelement, das aus fünf solchen Leuchtelementen besteht, ist trotz eines Kurzschlusses immer noch eine Lichtabstrahlung von etwa 98 % zu beobachten. Dies gilt, wenn der Kurzschluss in der Mitte einer Teilelektrode auftritt. Entsteht er noch weiter weg vom Anschlusskontakt, wird der ITO-Bahnwiderstand noch größer und damit der Kurzschlussstrom noch einmal um einen Faktor von maximal zwei kleiner. Das heißt, in diesem Fall werden immer noch 99% des Lichtes vom Beleuchtungselement abgegeben.

Die ungünstigste Position für einen Kurzschluss liegt in dem zum Anschlusskontakt benachbarten Bereich der Teilelektroden. Dann wird lediglich eine Teilelektrodenlänge von 3mm wirksam (entsprechend dem Abstand zweier aufeinander folgender Metallelektroden), also ein Zuleitungswiderstand von 60Ohm. Dieses bedeutet, dass das Leuchtelement etwa mit 75% Helligkeit weiter leuchtet, das gesamte organische Leuchtbauelement sogar immer noch mit 95%. Es ergibt sich also, dass auch im ungünstigsten Fall eines Kurzschlusses das organische Leuchtbauelement noch sehr gut funktionstüchtig ist.

Je geringer das Verhältnis von A zu D ist, desto größer ist die Auswirkung eines Kurzschlusses nahe des benachbarten Anschlusskontaktes. Daher ist das Verhältnis A:D zweckmäßig größer als 1, bevorzugt größer als 3 und weiter bevorzugt größer 10. Bei einem Verhältnis A:D von 1 erscheint ein Leuchtbauelement mit beispielsweise 100 Teilelektroden im Falle eines Kurzschlusses nahe des Anschlusskontaktes durch Verwendung einer Streufolie dem Betrachter unter ausreichendem Abstand noch homogen leuchtend bei Betrachtung mit bloßem Auge, d. h. ohne spezielles Vergrößerungsmittel, zum Beispiel eine Lupe. Sofern das Verhältnis A:D in diesem Falle drei beträgt, wäre ein homogenes Erscheinungsbild auch ohne eine Streufolie erreichbar. Bei einem Verhältnis von 10 könnte mittels einer Streufolie bereits bei einer Streifenzahl von 10 noch eine homogene Helligkeit von einem Betrachter in ausreichendem Abstand wahrgenommen werden.

Befinden sich auf einem organischen Leuchtbauelement oder gar auf einem Leuchtelement gleich mehrere Kurzschlüsse, so bleibt das Bauelement immer noch funktionstüchtig, allerdings reduziert sich die Effizienz mit jedem hinzukommenden Kurzschluss weiter.

Eine Variante, das Leuchtbauelement auch bei Kurzschluss noch effizienter zu gestalten, besteht darin, die Teilelektroden noch dünner zu gestalten. Dann lässt sich das Verhältnis des Stromes durch den Kurzschluss und dem Strom durch den restlichen Bereich des Leuchtelementes noch weiter verbessern. Allerdings ist es nicht zweckmäßig, die streifenförmigen Teilelektroden dünner zu machen, als die typische laterale Ausdehnung eines Kurzschlusses, Teilelektroden dünner als $10 \mu m$ sind daher nicht sinnvoll.

Mit der Erfindung wird es insbesondere ermöglicht, die Produktionsausbeute deutlich zu erhöhen, da Leuchtbauelemente auch dann noch verwendet werden können, wenn sich vereinzelte Kurzschlüsse gebildet haben.

Um die optische Erscheinung weiter zu verbessern, kann es vorgesehen sein, Strcuelemente in das Leuchtbauelement zu integrieren, wodurch zum einen die nicht leuchtenden Bereiche zwischen den Teilelektroden und zum anderen die durch Kurzschlüsse ausgefallenen Bereiche mittels Streulicht anderer, leuchtender Bereiche überdeckt werden.

Es kann auch vorgesehen sein, nicht die substratseitige Grundelektrode sondern die Deckelektrode zu strukturieren, insbesondere in Streifen. Dies kann beispielsweise mittels Laserbehandlung einer flächigen Deckelektrode erfolgen, welche dann quasi in Streifen geschnitten wird. Hierbei können sogar die unter den zu entfernenden Bereichen der Deckelektrode befindliche Bereiche des organischen Schichtstapels beschädigt werden ohne das hierdurch die Funktionalität des Gesamtbauelementes beeinträchtigt wird, da die so behandelten Bereiche sowieso nicht leuchten.

Die vorgeschlagenen organischen Leuchtbauelemente, ob nun mit einem oder mehreren elektrisch in Reihe geschalteten Leuchtelementen, können auch in Displays eingesetzt werden, um Pixelelemente zu bilden, insbesondere für Displays mit sehr großen Pixelelementen mit einer Größe von mehreren Quadratzentimetern, zum Beispiel bei Stadionleinwänden oder dergleichen. Hier wird aufgrund der Leuchtelemente vermieden, dass im Falle eines Kurzschlusses gleich ein ganzer Pixel ausfällt. Stattdessen wird durch den Betrachter eine nur leicht verringerte Helligkeit eines Pixels, die nicht weiter ins Gewicht fällt, festgestellt.

Besonders gering fällt der Effizienzverlust des Leuchtbauelementes aus, wenn die im Bereich der Streifenelektroden gebildeten Bauelemente selber einen geringen ohmschen Widerstand bei der Betriebshelligkeit haben. Dies ist insbesondere bei OLED-Bauelementen mit elektrisch dotierten Bereichen in dem organischen Schichtstapel der Fall.

Besonders homogen ist die Lichtabstrahlung des Leuchtbauelementes, wenn die Luminanz-Spannungs-Kennlinie im Bereich der Betriebshelligkeit nicht zu steil ist. Das ist zum Beispiel der Fall, wenn ein Spannungsunterschied von 0,4V einen Helligkeitsunterschied von maximal 40%, bevorzugt von maximal 20% verursacht.

Eine vereinfachte Näherungsformel ergibt für den prozentualen Effizienzverlust V des vorgeschlagenen Leuchtbauelementes beim Auftreten eines Kurzschlusses an einer Position, die um eine Strecke K entfernt ist vom Anschlusskontakt des benachbarten Leuchtelementes, wobei A < K < B gelte:

$$V = U{*}E \: / \: (M{*}N{*}B{*}H{*}S{*}K)$$

Hieraus ergeben sich eine Reihe weiterer Designregeln. Die einzige Größe, die nicht beeinflusst werden kann, ist offenbar K, die Position des Kurzschlusses. Ansonsten gilt, dass die Effizienzverluste im Fall eines Kurzschlusses dann besonders gering ausfallen, wenn

- die Betriebsspannung der auf den Teilelektroden gebildeten OLED-Bauelemente klein ist, zweckmäßig kleiner als 10V, bevorzugt kleiner als 6V und weiter bevorzugt kleiner als 4V;
- die Anzahl der Leuchtelemente des organischen Leuchtbauelementes groß ist, zweckmäßig größer als 10, bevorzugt größer als 27 und weiter bevorzugt größer als 55;
- die Anzahl der streifenförmigen Teilelektroden groß ist, zweckmäßig größer als 10, bevorzugt größer als 30 und weiter bevorzugt größer als 100;
- die auf den Teilelektroden gebildeten OLED-Bauelemente ausreichend hell betrieben werden, zweckmäßig mit einer Helligkeit von wenigstens $500 cd/m^2$, bevorzugt mit einer Helligkeit von wenigstens $1000 cd/m^2$ und weiter bevorzugt mit einer Helligkeit von wenigstens $5000 cd/m^2$.

Das Produkt aus S und B wird gesondert betrachtet. Je größer S ist, desto kürzer muss B sein, weil andernfalls die Ohmschen Verluste im Normalbetrieb über dem ITO zu groß werden und damit das Bauelement zu ineffizient wäre. Gute Ergebnisse werden erzielt, wenn das Produkt S*B zwischen 10 und 1000mm*Ohm/Quadrat liegt, bevorzugt zwischen 100 und 1000 mm*Ohm/Quadrat.

Die in der vorstehenden Beschreibung, den Ansprüchen und der Zeichnung offenbarten Merkmale der Erfindung können sowohl einzeln als auch in beliebigen Kombinationen für die Verwirklichung der Erfindung in ihren verschiedenen Ausführungsformen von Bedeutung sein.

**Patentansprüche**

1. Organisches Leuchtbauelement, insbesondere organische Leuchtdiode, mit:

    - einem Leuchtelement (1 ; 2) und
    - einer von dem Leuchtelement (1; 2) umfassten Leuchtfläche (1f; 2f), die mittels einer Elektrode (1a; 2a), einer Gegenelektrode (1d; 2d) und einer organischen Schichtanordnung (1e; 2e) gebildet ist, die zwischen der Elektrode (1a; 2a) und der Gegenelektrode (1d; 2d) angeordnet und in elektrischem Kontakt mit der Elektrode (1a; 2a) und der Gegenelektrode (1d; 2d) ist,

wobei im Bereich der Leuchtfläche (1f; 2f) angeordnete und beim Anlegen einer elektrischen Spannung an die Elektrode (1a; 2a) und die Gegenelektrode (1d; 2d) Licht abgebende Abschnitte der organischen Schichtanordnung (1e; 2e) einen einheitlichen organischen Materialaufbau aufweisen und auf mehreren elektrisch parallel geschalteten Teilelektroden (1b; 2b) der Elektrode (1a; 2a) gebildet sind, die auf einer Seite endseitig miteinander elektrisch verbunden und auf der gegenüberliegenden Seite elektrisch nicht verbunden sind, **dadurch gekennzeichnet, dass** die mehreren elektrisch parallel geschalteten Teilelektroden (1b; 2b) als Streifenelektroden gebildet sind, die entlang einer einfach oder mehrfach gekrümmten Linie oder einer Zickzack-Linie verlaufen, und ein seitlicher Abstand zwischen benachbarten der mehreren elektrisch parallel geschalteten Teilelektroden (1b; 2b) kleiner als die Hälfte der Breite der benachbarten Teilelektroden (1b; 2b) ist.

2. Leuchtbauelement nach Anspruch 1, **dadurch gekennzeichnet, dass** der seitliche Abstand zwischen den benachbarten Teilelektroden (1b; 2b) kleiner als ein Drittel der Breite der benachbarten Teilelektroden (1b; 2b) ist.

3. Leuchtbauelement nach einem der vorangehenden Ansprüche, **dadurch gekennzeichnet, dass** die organische Schichtanordnung (1e; 2e) im Bereich der 1-euchtfläclie (1f; 2f) durchgehend gebildet ist.

4. Leuchtbauelement nach einem der vorangehenden Ansprüche, **dadurch gekennzeichnet, dass** die Anzahl der mehreren Teilelektroden (1b; 2b) der Elektrode (1a; 2a) wenigstens 10 beträgt, bevorzugt wenigstens 30 und weiter bevorzugt wenigstens 100.

5. Leuchtbauelement nach einem der vorangehenden Ansprüche, **gekennzeichnet durch** eine maximale Betriebsspannung für das Leuchtelement (1; 2) von weniger als 10V, bevorzugt von weniger als 6V und weiter bevorzugt von weniger als 4V.

6. Leuchtbauelement nach einem der vorangehenden Ansprüche, **gekennzeichnet durch** eine maximale Betriebshelligkeit im Bereich der Leuchtfläche (1f; 2f) von wenigstens 500ed/m², bevorzugt von wenigstens 1000cd/m² und weiter bevorzugt von wenigstens 5000cd/m²

7. Leuchtbauelement nach einem der vorangehenden Ansprüche, **dadurch gekennzeichnet, dass** die mehreren Teilelektroden (1b; 2b) jeweils mit einem Schichtwiderstand und der Breite gebildet sind, bei denen sich für das Produkt von Schichtwiderstand und Breite ein Wert zwischen 10 und 1000mm*Ohm/Quadrat ergibt, bevorzugt zwischen 100 und 1000mm*Ohm/Quadrat.

8. Leuchtbauelement nach einem der vorangehenden Ansprüche, **dadurch gekennzeichnet, dass** flächig überlappend mit der Leuchtfläche (1f; 2f) ein Licht streuendes Element gebildet ist.

9. Leuchtbauelement nach Anspruch 8, **dadurch gekennzeichnet, dass** das Licht streuende Element ein Licht streuendes Substrat umfasst, auf welches die Elektrode (1a; 2a), die Gegenelektrode (1d; 2d) und die organischen Schichtanordnung (1e; 2e) gestapelt sind.

10. Leuchtbauelement nach Anspruch 8 oder 9, **dadurch gekennzeichnet. dass** das Licht streuende Element eine Streufolie umfasst.

11. Leuchtbauelement nach einem der vorangehenden Ansprüche, **dadurch gekennzeichnet, dass** das Leuchtelement (1; 2) gemäß mindestens einer Bauart ausgewählt aus der folgenden Gruppe von Bauarten ausgeführt ist: transparentes Leuchtelement, top-emittierendes Leuchtelement, bottom-emittierendes und beidseitig emittierendes Leuchtelement.

12. Leuchtbauelement nach einem der vorangehenden Ansprüche, **dadurch gekennzeichnet, dass** die Leuchtfläche (1f; 2f) eine Flächengröße von mehreren Quadratzentimetern aufweist.

13. Leuchtbauelement nach einem der vorangehenden Ansprüche, **dadurch gekennzeichnet, dass** die organische Schichtanordnung (1e; 2e) eine oder mehrere dotierte Ladungsträgertransportschichten aufweist.

14. Leuchtbauelement nach einem der vorangehenden Ansprüche, **dadurch gekennzeichnet. dass** das Leuchtelement (1) mit mindestens einem weiteren Leuchtelement (2) gleicher Bauweise elektrisch in Reihe geschalten ist.

15. Leuchtbauelement nach Anspruch 14, **dadurch gekennzeichnet, dass** das Leuchtelement mit wenigstens zehn weiteren Leuchtelementen gleicher Bauweise elektrisch in Reihe geschalten ist, bevorzugt mit wenigstens siebenundzwanzig weiteren Leuchtelementen und weiter bevorzugt mit wenigstens fünfundfünfzig weiteren Leuchtelementen.

16. Leuchtbauelement nach Anspruch 14 oder 15, **dadurch gekennzeichnet, dass** ein Abstand zwischen benachbart zueinander gebildeten Randabschnitten der Gegenelektroden (1d, 2d) benachbarter Leuchtelemente (1, 2) größer als die jeweilige Breite der mehreren Teilelektroden (1b, 2b), bevorzugt größer als das Dreifache der jeweiligen Breite der mehreren Teilelektroden (1b, 2b) und weiter bevorzugt größer als das Zehnfache der jeweiligen Breite der mehreren Teilelektroden (1b, 2b) ist.

17. Verwendung eines organischen Leuchtbauelementes nach einem der vorangehenden Ansprüche in einer Vorrichtung ausgewählt aus der folgenden Gruppe von Vorrichtungen: Beleuchtungseinrichtung und Anzeigeeinrichtung.

## Claims

1. Organic light-emitting device, in particular an organic light-emitting diode, with:

    - a light-emitting element (1; 2) and
    - an illuminated surface (1f; 2f), comprising the light-emitting element (1; 2), and which is formed by means of an electrode (1a; 2a), a counter-electrode (1d; 2d) and an organic layer arrangement (1e; 2e), which is arranged between the electrode (1a; 2a) and the counter-electrode (1d; 2d), and is in electrical contact with the electrode (1a; 2a) and the counter-electrode (1d; 2d),

    wherein sections of the organic layer arrangement (1e; 2e), which are arranged in the region of the illuminated surface (1f; 2f), and which emit light when an electrical voltage is applied to the electrode (1a; 2a) and the counter-electrode (1d; 2d), have a uniform organic material structure, and are formed on a plurality of electrically parallel-connected sub-electrodes (1b; 2b) of the electrode (1a; 2a), which at one side are electrically connected to one another, and on the opposite side are not electrically connected, **characterised in that** the plurality of electrically parallel-connected sub-electrodes (1b; 2b) are formed as strip electrodes, which extend along a singly or multiply curved line, or a zigzag line, and a lateral distance between adjacent members of the plurality of electrically parallel-connected sub-electrodes (1b; 2b) is less than half the width of the adjacent sub-electrodes (1b; 2b).

2. The light-emitting device according to claim 1, **characterised in that** the lateral distance between the adjacent sub-electrodes (1b; 2b) is less than one third of the width of the adjacent sub-electrodes (1b; 2b).

3. The light-emitting device according to one of the preceding claims, **characterised in that** the organic layer arrangement (1e; 2e) is formed throughout the region of the illuminated surface (1f; 2f).

4. The light-emitting device according to one of the preceding claims, **characterised in that** the number of the plurality of sub-electrodes (1b; 2b) of the electrode (1a; 2a) is at least 10, preferably at least 30, and more preferably at least 100.

5. The light-emitting device according to one of the preceding claims, **characterised by** a maximum operating voltage for the light-emitting element (1; 2) of less than 10 V, preferably of less than 6 V, and more preferably of less than 4 V.

6. The light-emitting device according to one of the preceding claims, **characterised by** a maximum operating brightness in the region of the illuminated surface (1f; 2f) of at least 500 cd/m$^2$, preferably of at least 1,000 cd/m$^2$, and more preferably of at least 5,000 cd/m$^2$.

7. The light-emitting device according to one of the preceding claims, **characterised in that** the plurality of sub-electrodes (1b; 2b) are each formed with a layer resistance and a width, in which, for the product of layer resistance and width, a value results of between 10 and 1000 mm*ohm/square, preferably of between 100 and 1000 mm*ohm/square.

8. The light-emitting device according to one of the preceding claims, **characterised in that** a light-scattering element is formed, which overlaps the illuminated surface (1f; 2f) in a planar manner.

9. The light-emitting device according to claim 8, **characterised in that** the light-scattering element comprises a light-scattering substrate, on which the electrode (1a; 2a), the counter electrode (1d; 2d), and the organic layer arrangement (1e; 2e) are stacked.

10. The light-emitting device according to claim 8 or 9, **characterised in that** the light-scattering element comprises a scattering film.

11. The light-emitting device according to one of the preceding claims, **characterised in that** the light-emitting element (1; 2) is embodied in accordance with at least one design selected from the following group of designs: a transparent light-emitting element, a top-emitting light-emitting element, a bottom-emitting and double-sided emitting light-emitting element.

12. The light-emitting device according to one of the preceding claims, **characterised in that** the illuminated surface (1f; 2f) has a surface area of several square centimetres.

**13.** The light-emitting device according to one of the preceding claims, **characterised in that** the organic layer arrangement (1e; 2e) comprises one or a plurality of doped charge carrier transport layers.

**14.** The light-emitting device according to one of the preceding claims, **characterised in that** the light-emitting element (1) is electrically connected in series with at least one other light-emitting element (2) of the same construction.

**15.** The light-emitting device according to claim 14, **characterised in that** the light-emitting element is electrically connected in series with at least ten other light-emitting elements of the same construction, preferably with at least twenty-seven other light-emitting elements, and more preferably with at least fifty-five other light-emitting elements.

**16.** The light-emitting device according to Claim 14 or 15, **characterised in that** a distance between adjacent edge sections of the counter electrodes (1d, 2d) of adjacent light-emitting elements (1; 2) is greater than the respective width of the plurality of sub-electrodes (1b, 2b), preferably greater than three times the respective width of the plurality of sub-electrodes (1b, 2b), and more preferably greater than ten times the respective width of the plurality of sub-electrodes (1b; 2b).

**17.** Use of an organic light-emitting device according to one of the preceding claims, in a device selected from the following group of devices: illumination devices and display devices.

**Revendications**

**1.** Composant d'éclairage organique, en particulier diode électroluminescente organique, avec :

  - un élément d'éclairage (1 ; 2) et
  - une surface lumineuse (1f ; 2f) comprise par l'élément d'éclairage (1 ; 2), laquelle est formée au moyen d'une électrode (1a ; 2a), d'une contre-électrode (1d ; 2d) et d'un agencement de couches organiques (1e; 2e), lequel est disposé entre l'électrode (1a ; 2e) et la contre-électrode (1d ; 2d) et est en contact électrique avec l'électrode (1a ; 2a) et la contre-électrode (1d ; 2d),

  dans lequel des parties de l'agencement de couches organiques (1e ; 2e) disposées dans la zone de la surface lumineuse (1f; 2f) et émettant de la lumière lors de l'application d'une tension électrique à l'électrode (1a ; 2a) et à la contre-électrode (1d ; 2d) présentent une configuration de matériau organique uniforme et sont formées sur plusieurs électrodes partielles (1b ; 2b) de l'électrode (1a ; 2a) connectées électriquement en parallèle, lesquelles sont reliées électriquement entre elles du côté d'extrémité sur un côté et ne sont pas reliées électriquement sur le côté situé en vis-à-vis, **caractérisé en ce que** les plusieurs électrodes partielles (1b; 2b) connectées électriquement en parallèle sont réalisées en tant qu'électrodes en bande qui s'étendent le long d'une ligne à une courbe ou plusieurs courbes ou une ligne en zigzag, et qu'un espacement latéral entre des électrodes partielles (1b ; 2b) voisines des plusieurs électrodes partielles connectées électriquement en parallèle est inférieur à la moitié de la largeur des électrodes partielles (1b ; 2b) voisines.

**2.** Composant d'éclairage selon la revendication 1, **caractérisé en ce que** l'espacement latéral entre les électrodes partielles (1b ; 2b) voisines est inférieur à un tiers de la largeur des électrodes partielles (1b ; 2b) voisines.

**3.** Composant d'éclairage selon l'une des revendications précédentes, **caractérisé en ce que** l'agencement de couches organiques (1e ; 2e) est réalisé de bout en bout dans la zone de la surface lumineuse (1f ; 2f).

**4.** Composant d'éclairage selon l'une des revendications précédentes, **caractérisé en ce que** le nombre des plusieurs électrodes partielles (1b ; 2b) de l'électrode (1a ; 2a) est au moins de 10, de préférence au moins de 30, et de manière davantage préférée, au moins de 100.

**5.** Composant d'éclairage selon l'une des revendications précédentes, **caractérisé par** une tension de service maximale pour l'élément d'éclairage (1 ; 2) de moins de 10V, de préférence de moins de 6V, et de manière davantage préférée, de moins de 4V.

**6.** Composant d'éclairage selon l'une des revendications précédentes, **caractérisé par** une luminosité de fonctionnement maximale dans la zone de la surface lumineuse (1f; 2f) d'au moins 500cd/m$^2$, de préférence d'au moins 1000cd/m$^2$, et de manière davantage préférée, d'au moins 5000cd/m$^2$.

**7.** Composant d'éclairage selon l'une des revendications précédentes, **caractérisé en ce que** les plusieurs électrodes partielles (1b ; 2b) sont respectivement formées avec une résistance de couche et la largeur avec lesquelles, pour le produit de la résistance de couche par la largeur, on obtient une valeur comprise entre 10 et 1000mm*ohms/carré, de préférence comprise entre 100 et 1000mm*ohms/carré.

**8.** Composant d'éclairage selon l'une des revendications précédentes, **caractérisé en ce qu'**en chevauchement en nappe avec la surface lumineuse (1f ; 2f), un élément de diffusion de lumière est formé.

9. Composant d'éclairage selon la revendication 8, **caractérisé en ce que** l'élément de diffusion de lumière comprend un substrat de diffusion de lumière sur lequel l'électrode (1a ; 2a), la contre-électrode (1d ; 2d) et l'agencement de couches organiques (1e ; 2e) sont empilés.

10. Composant d'éclairage selon la revendication 8 ou 9, **caractérisé en ce que** l'élément de diffusion de lumière comprend une pellicule de diffusion.

11. Composant d'éclairage selon l'une des revendications précédentes, **caractérisé en ce que** l'élément d'éclairage (1 ; 2) est réalisé selon au moins un type sélectionné dans le groupe suivant de types : élément d'éclairage transparent, élément d'éclairage d'émission sur le haut, élément d'éclairage d'émission sur le bas et d'émission sur les deux côtés.

12. Composant d'éclairage selon l'une des revendications précédentes, **caractérisé en ce que** la surface lumineuse (1f ; 2f) présente une superficie de plusieurs centimètres carrés.

13. Composant d'éclairage selon l'une des revendications précédentes, **caractérisé en ce que** l'agencement de couches organiques (1e ; 2e) présente une ou plusieurs couches de transport de porteurs de charge dopées.

14. Composant d'éclairage selon l'une des revendications précédentes, **caractérisé en ce que** l'élément d'éclairage (1) est connecté électriquement en série avec au moins un autre élément d'éclairage (2) de même type.

15. Composant d'éclairage selon la revendication 14, **caractérisé en ce que** l'élément d'éclairage est connecté électriquement en série avec au moins dix autres éléments d'éclairage de même type, de préférence avec au moins vingt-sept autres éléments d'éclairage, et de manière davantage préférée, avec au moins cinquante-cinq autres éléments d'éclairage.

16. Composant d'éclairage selon la revendication 14 ou 15, **caractérisé en ce qu'**un espacement entre des parties de bord réalisées de manière voisine entre elles des contre-électrodes (1d, 2d) d'éléments d'éclairage (1, 2) voisins est supérieur à la largeur respective des plusieurs électrodes partielles (1b, 2b), de préférence supérieur au triple de la largeur respective des plusieurs électrodes partielles (1b, 2b) et de manière davantage préférée, supérieur à dix fois la largeur respective des plusieurs électrodes partielles (1b, 2b).

17. Utilisation d'un composant d'éclairage organique selon l'une des revendications précédentes dans un dispositif sélectionné dans le groupe suivant de dispositifs : un dispositif d'éclairage et un dispositif d'affichage.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2392023 A
- US 2005174064 A1
- US 2006066223 A1
- WO 0156000 A2
- EP 1701395 A1
- DE 10058578 C1

**In der Beschreibung aufgeführte Nicht-Patentliteratur**

- **FORREST et al.** *Adv. Mat.,* 2004, vol. 7, 624
- **HE et al.** 85. *Appl. Phys. Lett.,* 2004, 3911